# EUROPEAN PATENT APPLICATION

(11) **EP 2 398 044 A2**
(43) Date of publication of application: **21.12.2011**
(21) Application number: 11170376.5
(22) Date of filing: 17.06.2011
(51) Int. Cl.: H01L 21/314, H01L 31/18, H01L 31/0216, H01L 31/068

(54) **Method for passivating a silicon surface**

(30) Priority: 17.06.2010 US 355996 P
(71) Applicant: Katholieke Universiteit Leuven, K.U.L. Leuven R&D, 3000 Leuven (BE); IMEC, 3001 Leuven (BE)
(72) Inventor: Vermang, Bart, 3000 Leuven (BE); Rothschild, Aude, 1030 Brussel (BE); Bearda, Twan, 2800 Mechelen (BE)
(74) Representative: Bird Goën & Co

(57) **Abstract**

A method for passivating a silicon surface, the method comprising the steps of: (a) cleaning of the silicon surface whereby the cleaning comprises subjecting the silicon surface to a sequence of steps wherein the final step is a chemical oxidising step resulting in a hydrophilic silicon surface, (b) drying the cleaned silicon surface using an advanced drying technique, and, (c) depositing an oxide layer on the silicon surface.

## Description

### Technical field of the invention

This present invention relates to methods for passivating a silicon surface. The methods of the present disclosure can for example be used for surface passivation of silicon photovoltaic cells.

### Background of the invention

The silicon photovoltaic industry uses ever thinner wafers to reduce significantly the silicon content per wafer, thereby reducing the cost of photovoltaic cells. Consequently the surface-to-volume ratio of the cells increases, and therefore the need for providing a good surface passivation of bulk silicon photovoltaic cells gains importance.

Because of the high sensitivity of the silicon bulk minority carrier lifetime as measured via the quasi-steady-state photo-conductance (QSSPC) method to high temperature processes, especially for multi-crystalline silicon wafers, low-temperature surface passivation processes are being developed for future industrial high-efficiency silicon photovoltaic cells. For example, it has been shown, for example by in G. Agostinelli et al in "Very low surface recombination velocities on p-type silicon wafers passivated with a dielectric with fixed negative charge", Solar Energy Materials & Solar Cells 90 (2006) 3438-3443, that thin films of aluminium oxide (Al₂O₃) grown by atomic layer deposition (ALD) can provide a good surface passivation on p-type and n-type silicon wafers. On p-type crystalline silicon surfaces, a fixed negative charge density within the Al₂O₃ layer can induce an accumulation layer that provides an effective field-effect passivation. Therefore, ALD-deposited Al₂O₃ can advantageously be used for p-type rear surface passivation of photovoltaic cells, such as for example for PERC-type (passivated emitter and rear contacts) photovoltaic cells and for PERL-type (passivated emitter rear locally diffused) photovoltaic cells.

In "Silicon surface passivation by atomic layer deposited Al2O3", Journal of Applied Physics volume 104, page 44903 (2008), B. Hoex et al provided an evaluation of the properties of ALD Al₂O₃ films in the context of their potential for application as surface passivation films in crystalline silicon photovoltaic cells. Al₂O₃ films with a thickness in the range between 7 nm and 30 nm were grown on both sides of crystalline silicon wafers with hydrogen terminated surfaces by plasma-assisted ALD or by thermal ALD. The layers were grown at a temperature of 200ºC under saturated self-limiting conditions, and a post-metal oxide-deposition annealing was performed at 425ºC for 30 minutes in a nitrogen atmosphere. This post-metal oxide-deposition annealing was considered essential for obtaining a high level of surface passivation. It was observed, both for n-type wafers and for p-type wafers, that the level of surface passivation increased with increasing film thickness in the studied thickness range. Depending on the ALD reactor used, non-uniformities in surface-passivation quality were detected over the passivated surface. When comparing thermal ALD with plasma-assisted ALD, it was found that for the process conditions used the effective lifetime obtained with thermal ALD was significantly lower than the effective lifetime obtained with plasma assisted ALD. This could be related to significant differences in the fixed-charge density in these layers.

In "Characterization and implementation of thermal ALD Al2O3 as surface passivation for industrial Si solar cells", 24th European PVSEC, 21-25 September 2009, B. Vermang et al reported surface passivation by means of Al₂O₃ films deposited by thermal ALD at a deposition temperature of 200ºC, followed by a post-metal oxide-deposition treatment at a temperature in the range of 200ºC to 500ºC, in a mixture of 10 volume % H₂ and 90 volume % nitrogen Three surface preparations were carried out, namely: Piranha and RCA cleans and growing a chemical oxide in a H₂SO₄:H₂O₂ solution. Piranha clean stands for a H₂SO₄:H₂O₂ cleaning and followed by HF dip. Whereas RCA clean represents an extended cleaning: (a) H₂SO₄:H₂O₂ cleaning followed by HF dip, (b) NH₄OH:H₂O₂:H₂O cleaning followed by HF dip and (c) HCl:H₂O₂:H₂O cleaning followed by HF dip. Piranha and RCA leave a hydrogen terminated surface before deposition. The third method involved the hydroxyl terminated surface, prepared by growing a chemical oxide in a H₂SO₄:H₂O₂ solution. Experiments were performed on hydrogen-terminated silicon surfaces, obtained by performing an HF dip after wafer cleaning, and on hydroxyl-terminated silicon surfaces, obtained by chemical oxidation in a H₂SO₄:H₂O₂ solution. For as-deposited thermal ALD layers, the minority carrier lifetimes determined were up to five times higher for wafers with hydrogen terminated surfaces (up to ca. 40 µs) than for wafers with hydroxyl terminated surfaces (up to ca. 8 µs). After thermal post-metal oxide-deposition treatment similar lifetimes were obtained for both surface terminations (up to ca. 100 µs). No information was given about the uniformity of the surface passivation quality over the passivated surface. The thermal ALD Al₂O₃ layers were used in an Al₂O₃/SiNₓ dielectric passivation stack to make local BSF multi-crystalline photovoltaic cells.

### Summary of the invention

It is an object of the present invention to provide electronic structures comprising a good surface passivation and methods for fabricating such structures.

It is an advantage of methods according to the present invention that a stable pre-metal oxide-deposition cleaning is provided, resulting in a hydroxyl-terminated surface.

It is a further advantage of the method according to the present invention, that a very good pre-metal oxide-deposition surface finishing can be provided.

It is a still further advantage of a method according to the present invention that a higher growth rate can be obtained during deposition on a hydroxyl-terminated surface than in methods wherein the ALD layer is grown on a hydrogen terminated surface.

In a first aspect, the present invention relates to a method for passivating a silicon surface, the method comprising the steps of:
(a) cleaning of said silicon surface, said cleaning comprising subjecting said silicon surface to a sequence of steps wherein the final step is a chemical oxidizing step resulting in a hydrophilic silicon surface,
(b) drying said cleaned silicon surface using an advanced drying technique, and,
(c) depositing an oxide layer on said silicon surface.

In embodiments of the present invention the sequence of steps comprises an alternating sequence of chemical oxidizing and oxide dissolution steps. Preferably the chemical oxidization is performed in an oxidizing mixture of ammonium hydroxide, hydrogen peroxide and water; or an oxidizing mixture of hydrogen chloride, hydrogen peroxide and water.

In other embodiments, the method further can comprise the removal of any oxide layers present on said silicon surface before said cleaning step (a). Preferably the removal of the oxide layers is performed by an HF-dip.

In another embodiment of the present invention the deposition of the oxide layer on the silicon surface is performed using thermal atomic layer oxidization. Preferably the thermal atomic layer oxidization is performed at a deposition temperature in the range between 150°C and 250°C, more preferably in the range between 175°C and 225°C.

In some embodiments the advanced drying technique is a Marangoni drying technique.

In a second aspect, the present invention relates to a photovoltaic device comprising a silicon surface and a passivated rear surface, wherein the passivation is performed using a passivation method according to any one of the embodiments of the present invention.

Examples of such structures are p-type rear surface passivated photovoltaic devices, such as passivated emitter and rear contact photovoltaic devices and passivated emitter rear locally diffused devices.

In other embodiments the structures comprise a silicon surface having a surface of 125 mm x 125 mm and a thickness of 160 µm, or wherein the silicon surface has a electrical resistivity between 0.5 to 3 Ohm-cm, or wherein the silicon surface is grown using a Czochraliski process, or wherein the silicon surface is grown using a float-zone process.

Certain inventive embodiments of the first aspect relate to a method for low-temperature surface passivation of silicon surfaces. Advantageously by applying the method the surface passivation quality is improved as compared to prior art low-temperature surface passivation methods and additionally the uniformity of the surface passivation quality over the passivated surface is improved as compared to prior art methods.

According to a first aspect of the present invention, a method for low-temperature surface passivation of a silicon surface is provided comprising the steps of: chemically oxidizing the silicon surface to be passivated using an oxidizing solution; drying the surface using an advanced drying technique, as compared to for instance hot air drying techniques which is typically used in the photovoltaic industry; and depositing an oxide layer, preferably a metal oxide layer, on the silicon surface by thermal Atomic layer deposition (ALD), preferably at a deposition temperature lower than about 250ºC. The method may further comprise performing a thermal post-metal oxide deposition treatment.

Before chemically oxidizing the silicon surface, any oxide layer (such a native oxide layer or an oxide layer resulting from prior cleaning steps) present on the silicon surface is preferably removed, for example by performing an HF dip. Chemically oxidizing the silicon surface can, for example, be performed in an oxidizing solution comprising NH₄OH:H₂O₂:H₂O [e.g. 5 parts water (H₂O), 1 part 27% ammonium hydroxide (NH40H), 1 part 30% hydrogen peroxide (H₂O₂) (RCA-1 cleanser)] or HCl:H₂O₂:H₂O [e.g. 6 parts water (H₂O), 1 part 27% hydrogen chloride (HCl). 1 part 30% hydrogen peroxide (H₂O₂) (RCA2 cleanser)].

Preferably an advanced drying technique is a drying technique that allows good surface contamination control, i.e. a drying technique wherein substantially no contaminating elements (such as for example water, drying marks or other surface contaminating elements such as organics) are added to the surface or left on the surface after drying. Examples of advanced drying techniques are Marangoni drying (see "A new extremely clean drying process" by A.F.M. Leenaars et al, Langmuir 1990, 6, 1701-1703), well-controlled nitrogen drying in vacuum, single wafer spin drying and supercritical carbon dioxide drying.. Further examples of advanced drying techniques can be found in "Drying of High Aspect Ratio Structures: a comparison of drying techniques via electrical stiction analysis, Solid State Phenomena, volumes 145-146, page 87, (2009) or US 6,521,050 which discloses the common drying technique known as spin, rinse and dry (SRD), the above mentioned Marangoni technique and other mentioned drying techniques which involve replacing the DIW (deionized water) with another volatile compound.

In single wafer spin drying after 1 minute of dispensing the dHF (1 wt% aqueous solution of hydrofluoric acid) the wafers are subjected to a conventional spin rinse and drying sequence on a MP2000 tool (DNS, Dainippon Screen). The spin rotation is preferably performed at 3000 rpm. The rinse water used can be cleanroom UPW (ultra-pure water) with an oxygen weight concentration lower than 1 ppm or aerated UPW with a dissolved oxygen concentration of around 8.6 ppm.

In supercritical-CO₂ drying after a 1 minute dip into dHF, the dHF-solution can be displaced by IPA (isopropyl alcohol) in a three step dilution sequence using a home-made single wafer overflow tank. The wafers can then be manually transferred to a supercritical-CO₂ drying tool (automegasamdri 916B) taking care that the surface of the wafer always is covered by a film of liquid IPA. A conventional drying program can then be used with a critical point passage of around 4 minutes at 90 bar and 31 °C.

In some embodiments, the deposited metal oxide layer can for example be an Al₂O₃ layer, a HfOₓ layer or any other suitable metal oxide layer known to a person skilled in the art. In a preferred embodiment of the first aspect of the present invention, thermal ALD deposition is performed at a temperature in the range between about 150ºC and 250ºC, preferably in the range between about 175ºC and 225ºC, for example at about 200ºC.

According to a preferred embodiment of the first aspect of the present invention, the thermal post-metal oxide-deposition treatment is performed in a nitrogen atmosphere or in a Forming Gas atmosphere (forming gas, also known as dissociated ammonia, is a hydrogen-nitrogen mixtures with different mole fractions of hydrogen e.g. 10% hydrogen in nitrogen), preferably at a temperature in the range between about 200ºC and 500º, with the range between about 300ºC and 400ºC being particularly preferred and the range between about 330ºC and 370ºC being especially preferred.

According to another preferred embodiment of the first aspect of the present invention, the thickness of the thermal ALD layer is in the range between about 5 nm and 50 nm.

Methods according to embodiments of the first aspect can advantageously be used for passivating p-type silicon surfaces, for example for application in photovoltaic cells, more in particular for passivating the rear surface of local BSF (Back Surface Field) cells such as for example PERC-type cells or PERL-type cells.

Embodiments of the first aspect of the present invention provide a stable pre-metal oxide-deposition cleaning, resulting in a hydroxyl-terminated surface. Prior art "HF-last" cleaning sequences lead to hydrogen terminated silicon surfaces, and thus an unstable surface finishing, possibly leading to the growth of an unstable and uncontrollable native oxide and to surface contamination. This can be prevented in an embodiment of the first aspect of the present invention by using oxidized or hydroxyl terminated surfaces, for example by performing a chemical oxidation step in a suitable solution such as a H₄OH:H₂O₂:H₂O or HCl:H₂O₂:H₂O, leading to a stable oxide layer on the silicon surface.

Embodiments of the first aspect of the present invention provide a very good pre-metal oxide-deposition surface finishing. In prior art methods a hot-air dryer or a nitrogen gun is used for drying the substrates, leaving water marks or drying marks on the surface. In embodiments of the first aspect of the present invention, a more advanced drying technique such as Marangoni drying is used. Almost no water or drying marks are left after such a pre-metal oxide-deposition treatment, leading to a better uniformity of the surface passivation quality over the passivated surface.

Embodiments of the first aspect of the present invention enable a higher growth rate to be obtained during deposition than in methods wherein the ALD layer is grown on a hydrogen terminated surface. ALD Al₂O₃ growth on hydrogen terminated surfaces is known to be surface-inhibited. On the other hand, the growth on a well-chosen oxidized surface can be linear or even surface-enhanced, clearly increasing the surface growth.

According to a second aspect of the present invention, a photovoltaic cell is provided, more specifically photovoltaic cells comprising passivated emitter and rear contacts (PERC-type cells). The passivation of the rear surface is preferably performed using a method according to some embodiments of the present invention for rear surface passivation.

Certain objects and advantages of the disclosure have been described herein above. Of course, it is to be understood that not necessarily all such objects or advantages may be achieved in accordance with any particular embodiment of the disclosure. Thus, for example those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the drawings

Figure 1 shows carrier density images of double polished p-type silicon samples of 1.5 Ohm-cm resistivity and 710 micrometer thickness, passivated at both sides by means of a 30 nm thick Al₂O₃ layer, for different pre-metal oxide-deposition and post-metal-oxide-deposition treatments.
Figure 2 shows the measured effective lifetime of double polished p-type silicon samples of 1.5 Ohm-cm resistivity and 710 micrometer thickness, passivated at both sides by means of a 30 nm thick Al₂O₃ layer, for different pre-metal oxide-deposition treatments and annealed in forming gas.
Figure 3 shows the effective lifetime of a 2 Ohm-cm p-type float-zone (FZ) crystalline silicon substrate passivated with 30 nm Al₂O₃ and annealed in forming gas at 350ºC.
Figure 4 shows the effective surface recombination velocities measured as a function of excess carrier density after the annealing step of 1-3 Ohm-cm p-type silicon substrates passivated with 30 nm Al₂O₃ and annealed in forming gas at 350ºC, using different drying techniques.
Figure 5 shows the effective surface recombination velocities measured as a function of excess carrier density just after Al₂O₃ deposition of 1-3 Ohm-cm p-type silicon substrates passivated with 30 nm Al₂O₃, using different drying techniques.

In the different drawings, the same reference signs refer to the same or analogous elements.

### Detailed description of certain illustrative embodiments

In the following detailed description, numerous specific details are set forth in order to provide a thorough understanding of the invention and how it may be practiced in particular embodiments. However, it will be understood that the present invention may be practiced without these specific details. In other instances, well-known methods, procedures and techniques have not been described in detail, so as not to obscure the present disclosure. While the present invention will be described with respect to particular embodiments and with reference to certain drawings, the invention is not limited hereto. The drawings included and described herein are schematic and are not limiting the scope of the invention. It is also noted that in the drawings, the size of some elements may be exaggerated and, therefore, not drawn to scale for illustrative purposes.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and in the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising" should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

One embodiment according to the first aspect of the present invention provides a method for low-temperature surface passivation of a silicon surface, the method comprising: chemically oxidizing the silicon surface to be passivated using an oxidizing solution; drying the surface using an advanced drying technique; and depositing an oxide layer, preferably a metal oxide layer, such as for example an Al₂O₃ layer on the silicon surface by thermal Atomic layer deposition (ALD), preferably at a deposition temperature lower than about 250ºC.

Before chemically oxidizing the silicon surface, preferably any oxide layer (such a native oxide layer or an oxide layer resulting from prior cleaning steps) present on the silicon surface is removed, for example by performing an HF dip. After depositing the oxide layer, a thermal post-metal oxide-deposition treatment is preferably performed.

An advanced drying technique as used in disclosing the present invention, is a drying technique that allows a good surface contamination control, i.e. a drying technique wherein substantially no contaminating elements (such as for example water, drying marks or other surface contaminating elements such as organics) are added to the surface or left on the surface after drying.

An example of such an advanced drying technique is Marangoni drying (A.F.M. Leenaars et al, "Marangoni drying: a new extremely clean drying process", Langmuir 1990, 6, 1701-1708). Marangoni drying comprises withdrawing the sample from a (water) rinse bath while at the same time nitrogen gas with a trace of an organic vapor (such as IPA) is led along the surface. The organic vapor dissolves into the water and causes a surface tension gradient in the IPA:H₂O liquid wetting film on the surface, allowing gravity to more easily pull the liquid completely off the wafer surface, effectively leaving a dry wafer surface. As opposed to less advanced drying techniques such as spin drying or hot air drying, almost no contamination is added to the substrate surface during Marangoni drying.

Experiments were performed in which, after the different pre-metal oxide-deposition treatments or cleanings given in Table 1, a 30 nm thick Al₂O₃ layer was deposited using thermal ALD at a deposition temperature of 200ºC. Carrier density imaging (CDI) and quasi-steady-state photo-conductance (QSSPC) measurements were used to examine the passivation quality and uniformity of the Al₂O₃ passivation layer.

As shown in Table 1, sample (a) and sample (b) received an advanced cleaning sequence, the so-called "RCA clean" with and without an additional oxidation step, and an advanced drying technique, specifically a Marangoni drying, before the ALD deposition. Sample (c) received a less advanced cleaning sequence the so-called "Piranha clean" followed by a hot air drying step. Sample (a) received an oxidizing treatment in NH₄OH:H₂O₂:H₂O just before the drying step, resulting in an -OH terminated silicon surface. Sample (b) and sample (c) received an HF dip just before the drying step, resulting in a -H terminated silicon surface.

**Table 1**

| | **sample (a)** | **sample (b)** | **sample (c)** |
|---|---|---|---|
| | *Cleaning sequence* | *Cleaning sequence* | *Cleaning sequence* |
| *step 1* | H₂O₂:H₂SO₄ | H₂O₂:H₂SO₄ | H₂O₂:H₂SO₄ |
| *step 2* | HF | HF | HF |
| *step 3* | NH₄OH:H₂O₂:H₂O | NH₄OH:H₂O₂:H₂O | |
| *step 4* | HF | HF | |
| *step 5* | HCl:H₂O₂:H₂O | HCl:H₂O₂:H₂O | |
| *step 6* | HF | HF | |
| *step 7* | NH₄OH:H₂O₂:H₂O | | |
| *drying technique* | *Marangoni drying* | *Marangoni drying* | *Hot air drying* |
| surface species | **Si-OH** | **Si-H** | **Si-H** |

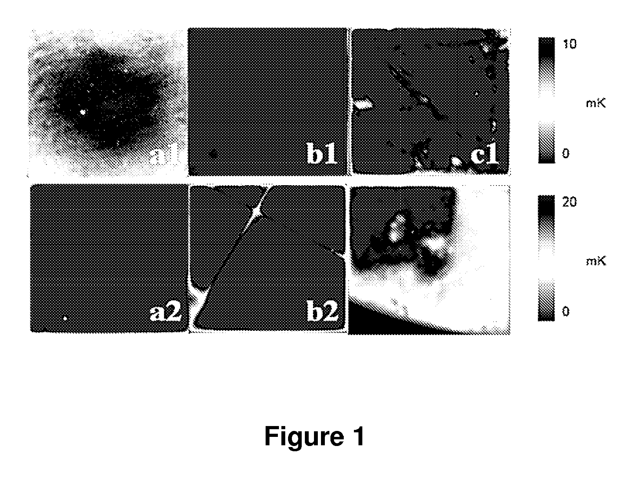

Figure 1 shows carrier density images measured on six double-sidedly polished, 710 micrometer thick p-type silicon samples (2 cm x 2 cm) having an electrical resistivity of 1.5 Ohm-cm and being passivated on both sides with a 30 nm thick thermal ALD Al₂O₃ layer deposited at 200ºC. The different samples received different pre-metal oxide-deposition treatments and different post-metal oxide-deposition treatments. Samples a1 and a2 were pre-treated using the cleaning sequence and drying step according to 'sample a' in Table 1; samples b1 and b2 were pre-treated using the cleaning sequence and drying step according to 'sample b' in Table 1; and samples c1 and c2 were pre-treated using the cleaning sequence and drying step according to 'sample c' in Table 1. No post-metal oxide-deposition treatment was performed on samples a1, b1 and c1. In the case of samples a2, b2 and c2 a post-metal oxide-deposition Forming Gas-Anneal was performed at 350ºC. The results shown in Figure 1 obtained after performing the thermal post-metal oxide-deposition treatment, it can be concluded that the cleaning sequence and drying technique used for samples a2 and b2 led to a more uniform passivation quality and to a better passivation as compared to the cleaning sequence and drying technique used for sample c2.

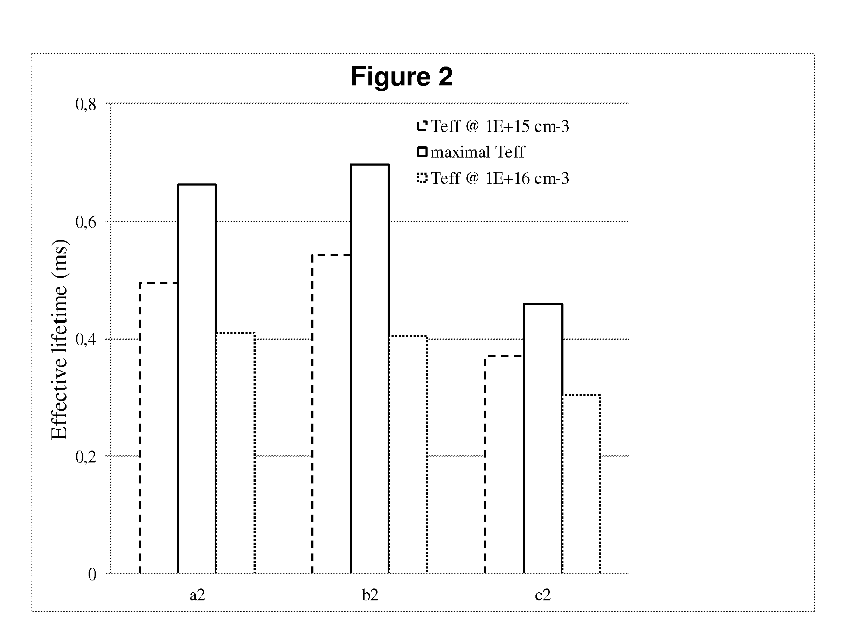

Figure 2 shows the effective lifetime of samples a2, b2 and c2 determined for different excess carrier densities. From the results it can be concluded that using an advanced drying technique (such as Marangoni drying) leads to higher effective lifetimes (and thus a better passivation quality), as compared to less advanced drying techniques such as hot air drying.

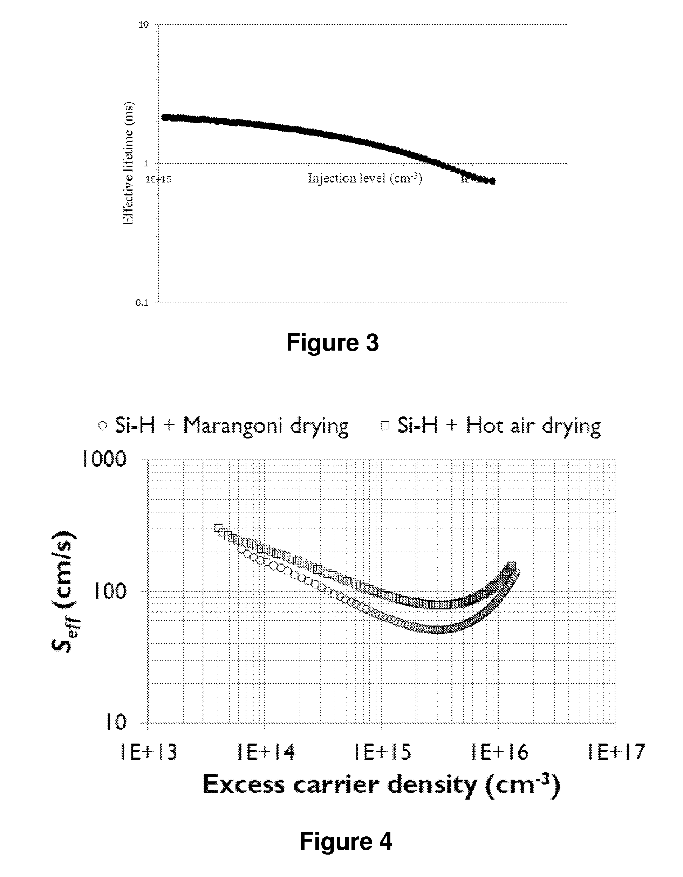

Figure 3 shows the effective lifetime in ms (measured by quasi-steady-state photo conductance (QSSPC)) of a 2 Ohm-cm p-type FZ crystalline silicon substrate passivated with 30 nm Al₂O₃ layer deposited by thermal ALD at a deposition temperature of 200ºC and annealed in Forming Gas at 350ºC, as a function of the injection level. Before ALD deposition, the substrate was cleaned in accordance with the cleaning of sample (a) in Table 1: a chemical oxidation step was performed, followed by Marangoni drying. Effective lifetime values up to 2.2 ms and surface recombination velocities down to 4.6 cm/s were achieved, indicating a good surface passivation quality.

In one embodiment of the first aspect, chemically oxidizing the silicon surface is performed in an oxidizing solution comprising NH₄OH:H₂O₂:H₂O or HCl:H₂O₂:H₂O. The chemically oxidizing solution is preferably selected such that traces of the oxidizing solution can be easily removed, e.g. rinsed off. Therefore, a chemical oxidizing solution having a not too high viscosity is preferably used. It has been shown that a chemical oxidizing solution having a high viscosity such as H₂O₂:HSO₄ is preferably avoided, because after rinsing traces of H₂O₂:HSO₄ remain on the surface, leading to a less uniform surface passivation of lower quality.

Drying the surface using an advanced drying technique may, for example, comprise Marangoni drying, as described above. However, the embodiment is not limited thereto and other advanced drying techniques known to a person skilled in the art can be used, such as for example well-controlled N₂ drying in vacuum.

The thermal post-metal oxide-deposition treatment may for example be performed in a nitrogen atmosphere or in a Forming Gas atmosphere, e.g. at a temperature in the range between about 200ºC and 500º, for example in the range between about 300ºC and 400ºC, for example between about 330ºC and 370ºC.

When used for surface passivation of photovoltaic cells, for example rear surface passivation of local BSF photovoltaic cells, a thin ALD passivation layer deposited according to one embodiment can be combined with other dielectric layers, such as silicon nitride layers or silicon oxide layers. Examples of passivation stacks that can be used are e.g. ALD Al₂O₃ / SiNₓ, ALD Al₂O₃ / SiOₓ, ALD Al₂O₃ / sol-gel Al₂O₃. However, the present invention is not limited thereto. As an alternative to ALD Al₂O₃, other materials can be used such as, for example, ALD HfOₓ.

Figure 4 shows the effective surface recombination velocities measured as a function of excess carrier density after the annealing step of 1-3 Ohm-cm p-type silicon substrates passivated with a 30 nm Al₂O₃ layer deposited by thermal ALD at 200ºC and annealed in forming gas at 350ºC, for which different drying techniques, such as Marangoni and hot air drying, were used after the cleaning sequence. The p-type silicon substrate was cleaned in a H₂SO₄:H₂O₂ solution at 85 ºC for 10 minutes, followed by an HF dip.

As is shown in Fig. 4 the surface passivation quality obtained was advantageously superior when using an advanced drying technique. Additionally, even after annealing the silicon substrate, the surface passivation quality is retained.

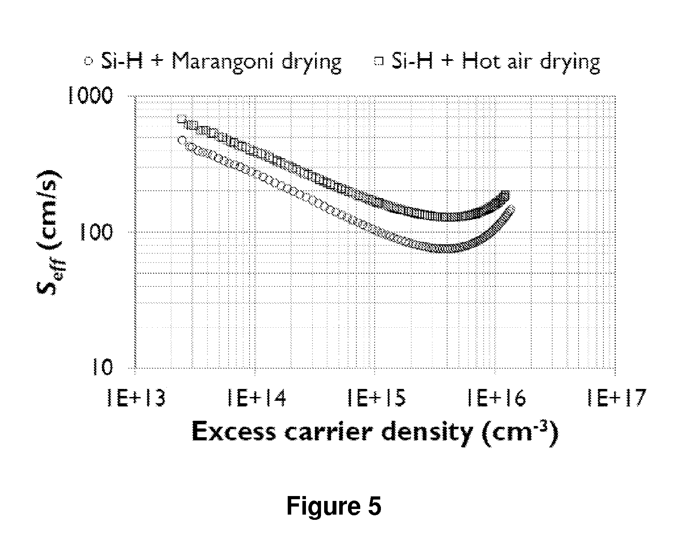

Figure 5 illustrates the effective surface recombination velocities (measured by QSSPC) as a function of excess carrier density just after Al₂O₃ deposition for Marangoni and hot air drying techniques.

PERC-type photovoltaic cells were fabricated wherein different methods were used for rear surface passivation. As a substrate, 125 mm x 125 mm semi-square p-type silicon wafers, grown using a Czochraliski process, were used with a resistivity of 0.5 to 3 Ohm-cm. After texturing the substrate, the rear side of the substrate was polished, resulting in a substrate thickness of 160 micrometer. Next a front-side phosphorous diffusion step (POCl₃ diffusion) was performed for forming an emitter region having a sheet resistance of 60 Ohm per square. Then the wafers were cleaned and dried using an advanced drying technique in accordance with some embodiments of the present invention. For a first part of the wafers a cleaning sequence leading to a hydrophobic surface (Si-H) was used. More specifically, the wafers were cleaned in a 1:4 H₂O₂:H₂SO₄ solution at 85ºC for 10 minutes, followed by an HF-dip (2% HF in deionized water) and Marangoni drying. For a second part of the wafers, a cleaning sequence leading to a hydrophilic surface (Si-OH) in accordance with the present invention was used. More in particular, these wafers were cleaned in a 1:4 H₂O₂:H₂SO₄ solution at 85ºC for 10 minutes, followed by an HF-dip (2% HF in deionized water), chemical oxidation in NH₄OH:H₂O₂:H₂O (1:1:5) for 10 minutes at ambient temperature and finally Marangoni drying. A thin Al₂O₃ layer (5 nm or 10 nm) was then deposited at the rear surface using thermal ALD at 200ºC, and an annealing step in a nitrogen environment was done at 400ºC. A PECVD SiNₓ capping layer was then deposited on the Al₂O₃ layer. At the rear side of the cell contact openings were made through the Al₂O₃/SiNₓ stack using laser ablation. This was followed by Al sputtering at the rear side for forming rear side contacts and Ag screen printing at the front side for forming front side contacts, and co-firing of the metal contacts using a 860ºC peak temperature.

For each of the process conditions (type of cleaning, Al₂O₃ layer thickness) five cells were fabricated. The open-circuit voltages (V_{oc}) were measured and the average V_{oc} values for each process condition are summarized in Table 2. From these results on cell level it can be concluded that also after processing of a complete photovoltaic cell, including a firing step at high temperature, an Al₂O₃ layer formed according to a method of the present invention provides a good surface passivation quality. The results do not show a significant difference between cells wherein the Al₂O₃ layer is deposited on a hydrophobic surface versus a hydrophilic surface.

As a reference, photovoltaic cells were fabricated using the same process sequence as described above, with a 5 nm thick Al₂O₃ layer and with hot air drying instead of Marangoni drying before Al₂O₃ deposition. For these cells an average open-circuit voltage of 627 mV was measured. This clearly illustrates the advantage of using an advanced drying technique.

**Table 2**

| | Si-H surface | Si-OH surface |
|---|---|---|
| 5 nm Al₂O₃ | 637 mV | 636 mV |
| 10 nm Al₂O₃ | 636 mV | 637 mV |

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method for passivating a silicon surface, said method comprising the steps of:
(a) cleaning of said silicon surface, said cleaning comprising subjecting said silicon surface to a sequence of steps wherein the final step is a chemical oxidising step resulting in a hydrophilic silicon surface,
(b) drying said cleaned silicon surface using an advanced drying technique, and,
(c) depositing an oxide layer on said silicon surface.

2. The method according to claim 1, wherein said sequence of steps comprises an alternating sequence of chemical oxidising and oxide dissolution steps.

3. The method according to claim 2, wherein said chemically oxidization is performed in an oxidizing mixture of ammonium hydroxide, hydrogen peroxide and water; or an oxidizing mixture of hydrogen chloride, hydrogen peroxide and water.

4. The method according to any one of claims 1 to 3, wherein said method further comprises the removal of any oxide layers present on said silicon surface before said cleaning step (a).

5. The method according to claim 4, wherein said removal of said oxide layers is performed by an HF-dip.

6. The method according to any one of the preceding claims, wherein said method further comprises the performance of a high temperature anneal step performed at a temperature in the range between about 200°C and 500°C, preferably in the range between 300 °C and 400 °C or between 330 °C and 370 °C, after said deposition step (b).

7. The method according to claim 6, wherein said high temperature anneal step is performed in a nitrogen atmosphere or in a Forming Gas Atmosphere.

8. The method according to any one of the preceding claims, wherein said deposition of said oxide layer on said silicon surface is performed using thermal atomic layer oxidization.

9. The method according to claim 8, wherein said thermal atomic layer oxidization is performed at a deposition temperature in the range between 150°C and 250°C, preferably in the range between 175 °C and 225 °C.

10. The method according to any one of the preceding claims, wherein said deposited oxide layer is a metal oxide layer.

11. The method according to claim 10, wherein said metal oxide layer is an Al₂O₃ layer or a HfOₓ layer or wherein said metal oxide layer has a thickness between 5 nm and 50 nm.

12. The method according to any one of the preceding claims, wherein said advanced drying technique is a Marangoni drying technique.

13. A photovoltaic device comprising a silicon surface and a passivated rear surface, wherein said passivation is performed using a passivation method according to any one of claims 1 to 12.

14. The device according to claim 13, wherein said photovoltaic device is a PERC-type or PERL-type cell.

15. The device according to any one of claims 13 and 14, wherein said silicon surface has a surface of 125 mm x 125 mm and a thickness of 160 µm, or wherein said silicon surface has a electrical resistivity between 0.5 to 3 Ohm-cm, or wherein said silicon surface is grown using a Czochraliski process, or wherein said silicon surface is grown using a float-zone process.
